# EUROPEAN PATENT SPECIFICATION

(11) **EP 1 741 650 B1**
(45) Date of publication and mention of the grant of the patent: **25.07.2012**
(21) Application number: 05734145.5
(22) Date of filing: 22.04.2005
(51) Int. Cl.: B65H 19/18, B65H 21/00

(54) **ANISOTROPIC CONDUCTIVE FILM HOLDING TAPE AND MOUNTING METHOD**
HALTEBAND UND MONTAGEVERFAHREN FÜR EINE ANISOTROPE LEITFÄHIGE FOLIE
BANDE DE MAINTIEN DE PELLICULE CONDUCTRICE ANISOTROPE ET PROCÉDÉ DE MONTAGE

(30) Priority: 28.04.2004 JP 2004134510; 09.07.2004 JP 2004203787
(43) Date of publication of application: 10.01.2007
(73) Proprietor: Sony Chemical & Information Device Corporation, Tokyo 141-0032 (JP)
(72) Inventor: IKEZAWA, Takafumi, c/o SONY CHEMICALS CORPORATION, Kanuma-shi, Tochigi 3228502 (JP)
(74) Representative: Robinson, Nigel Alexander Julian
(86) International application number: PCT/JP2005/007719
(87) International publication number: WO 2005/105633

(56) References cited:
- EP-A- 1 002 752
- EP-A- 1 306 334
- EP-A- 1 321 407
- DE-A1- 2 365 807
- JP-A- 5 246 592
- JP-A- 11 001 264
- JP-A- 2003 197 677
- JP-U- 50 097 890
- JP-U- 59 149 849
- US-A- 5 323 981
- US-A- 5 366 174

## Description

### Technical Field

This invention relates to an anisotropic conductive film carrying tape, used for a process for interconnecting a counterpart connecting member carrying a large number of electrodes, to an electronic part or component, as a connecting member facing the counterpart connecting member. The anisotropic conductive film carrying tape is used for a packaging process employing the anisotropic conductive film operating as a material for connection. This invention also relates to a method for packaging e.g. an electronic part or component using this anisotropic conductive film. Similar tapes and methods were disclosed in EP 1 002 752 A2, EP 1321407 A1 and US 5, 366,174
The present invention contains subject matter related to Japanese Patent Applications Nos.2004-134510 and 2004-203787, filed in the Japanese Patent Office on April 28, 2004 and on July 9, 2004, respectively.

### Background Art

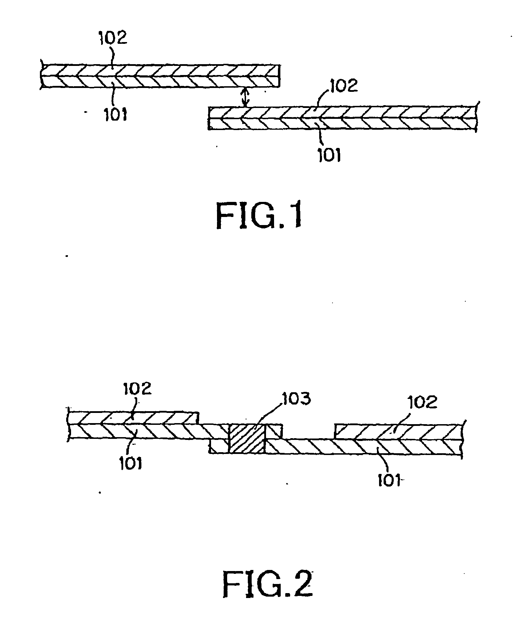

Heretofore, in a process of affixing electronic devices, parts or components, in a preset pattern, using an anisotropic conductive film, the tape which has the anisotropic conductive film, coated thereon, and which has been wrapped around a reel-type packaging device, is paid out by an operator from the tape reel and set in position. Hence, each time the tape has been paid out from a given reel, the operator has to set a new reel in position by a manual operation.
This reel exchange operation takes ten to thirty minutes per reel and, during this time, the packaging device is in a standstill state, with the production being in a state of cessation. Moreover, this reel exchange operation occurs several times a day, which means loss of much time and represents a principal factor in lowering the production efficiency.
There is a method for increasing the length of a product of the anisotropic conductive film for reducing the load of the reel exchange operation for overcoming the above problem. However, since the film is wound on a reel, there is a limitation to the radial size of the -tape wound on the reel, depending on the size of the device for packaging. In addition, if the tape carrying thereon an anisotropic conductive film of an excessive length is wound on a reel, it may be an occurrence that a given turn of the anisotropic conductive film is deviated from other turns, as the film is tightened, thus detracting from the quality of the anisotropic conductive film. This indicates that difficulties may be met in increasing the length of the anisotropic conductive film wound in a reel.
There has also been proposed a method consisting in interconnecting a plural -number of tapes, each carrying an anisotropic conductive film, and for continuously driving the tapes, in order to overcome the aforementioned problem. However, a PET layer 101 and an anisotropic conductive film 102 cannot be thermally fused together, as shown in Fig.1. On the other hand, if two PET layers 101 are to be connected to each other, as shown in Fig.2, difficulties are met in the fusing because of the high melting point of the PET layer. If such fusion could be achieved, there is a fear that the resulting product is lowered in quality because of insufficiency in strength caused by excessive melting of a weld 103.
EP-A-1 002 752 discloses a method for forming a continuous material by connecting sheet materials which are used in various fields including the processing of metal foils, the processing of metal-plastic composite film material, and the processing of thermoplastic resin films such as polyimides, and an apparatus used for carrying out this method. The method uses a connecting apparatus comprising a hot press, a material locking device and an accumulator, a continuous material can be formed by interposing a resin bonding layer between the trailing edge of a sheet material and the leading edge of another sheet material, and subjecting this part to thermocompression bonding.; Moreover, during thermocompression bonding, the material locking device is operated so that the part to be joined by thermocompression bonding comes to a standstill within the hot press, and the accumulator is also operated so that the feed speed of the sheet material on the downstream side is adjusted to a predetermined value. Thus, the completely connected sheet materials can be processed continuously.
US-A-5 323 981 discloses a splicer tape for holding down the leading end portion of the outer layer of a new roll of web and for enabling the leading end portion of the new roll to be spliced to the trailing end portion of an active web. The tape contains an elongated strip of carrier material having inner and outer sides with the inner side of the strip having a first and second longitudinally extending section and preferably having an intermediate longitudinally extending section located between the first and second sections, said intermediate section being free of adhesive. A first adhesive is applied onto the first section and comprises a non-releasable adhesive which is to be applied against the leading end portion of the new roll. A second adhesive is applied onto the second section of the inner side of the carrier strip and comprises a releasable adhesive which is to be applied against the body of the new roll to hold the leading edge of the new roll down until the leading edge of the new roll is spliced to the trailing end portion of the active web whereupon the second adhesive releases from the body of the new roll without leaving any portion of the tape on the roll body. A third adhesive is applied on the outer side of the carrier strip and it comprises a non-releasable adhesive which is to be applied against trailing end portions from the active web during splicing.
EP-A-1 321 407 discloses a method for splicing successive rolls of webmaterial to one endless web, in such way that during subsequent coating of the web, coating defects near the splices are reduced, preferably prevented. To that end at least part of the trailing edge of the splicing tape used to splice the succeeding webs, is left free of adhesive. Because of this, air, which during said coating process gets entrapped behind the splice, between the coating layer and the web, can dissipate between the adhesive-free tape edge and the underlying web surface, thus reducing or preventing the formation of air bubbles and subsequent coating defects. The possible reoccurrence of discontinuity coating defects at very high coating speeds can be reduced or prevented by subjecting the surface of the web to be coated to an electrostatic charge before applying the coating.

### Disclosure of the Invention

### Problems to be solved by the Invention

### Means to solve the Problem

It is an object of the present invention to provide an anisotropic conductive film carrying tape, which may be connected to another such tape easily reliably by thermal fusion, and a method for packaging electronic parts or components, for example, using this tape carrying thereon an anisotropic conductive film.
It is another object of the present invention to provide an anisotropic conductive film carrying tape in which a plural number of tapes, each carrying an anisotropic conductive film, are positively connected to one another to permit continued use of the tape to provide for effective elongation of the tape length without elongating the length of the individual tapes, and a packaging method. The production efficiency in the process of packaging the part or component on a substrate may be improved with the use of the anisotropic conductive film carrying tape.
Various aspects of the invention are set out in the accompanying claims.
Moreover, according to the present invention, the front and back surfaces of the splice tape, as a connecting part of the anisotropic conductive film carrying tape, are dyed to different colors, so that the front and back sides of the anisotropic conductive film carrying tape may be discriminated based on colored zones. Hence, the torsion of the anisotropic conductive film carrying tape may be detected and cured. Thus, according to the present invention, the tape torsion may be prevented, so that it is possible to interconnect the anisotropic conductive film carrying tapes of narrow tape widths that may be extremely liable to torsions.
Furthermore, according to the present invention, when an anisotropic conductive film carrying tape is about to be depleted, it may be connected to another anisotropic conductive film carrying tape easily reliably by thermal fusion in the course of the process of affixing the electronic devices or electronic parts or components with the use of the anisotropic conductive film carrying tape. Hence, the anisotropic conductive film carrying tape may be supplied in a continued manner without halting the operation, so that packaging may be carried out continuously without interrupting the driving.
Other objects and specified advantages of the present invention will become more apparent from the following explanation of preferred embodiments thereof especially when read in conjunction with the drawings.

### Brief Description of the Drawings

Fig. 1 is a cross-sectional view showing a conventional example of interconnecting an anisotropic conductive film -carrying tape to another such tape.
Fig.2 is a cross-sectional view showing another conventional example of interconnecting an anisotropic conductive film carrying tape to another such tape.
Fig.3 is a cross-sectional view showing an anisotropic conductive film carrying tape according to the present invention.
Fig.4 is a cross-sectional view showing the state of interconnection of two anisotropic conductive film carrying tapes according to the present invention.
Fig.5 is a schematic view showing a state in which, in the packaging method of the present invention, an anisotropic conductive film carrying tape of a first reel support has been supplied.
Fig.6 is a schematic view showing a process step of interconnecting anisotropic conductive film carrying tapes of the first and second reel supports in the packaging method of the present invention.
Fig.7 is a schematic view showing the state in which, in the packaging method of the present invention, the anisotropic conductive film carrying tape of the second reel support has been supplied and-the anisotropic conductive film carrying tape of the first reel support is exchanged for a newly supplied tape.

### Best Mode for Carrying out the Invention

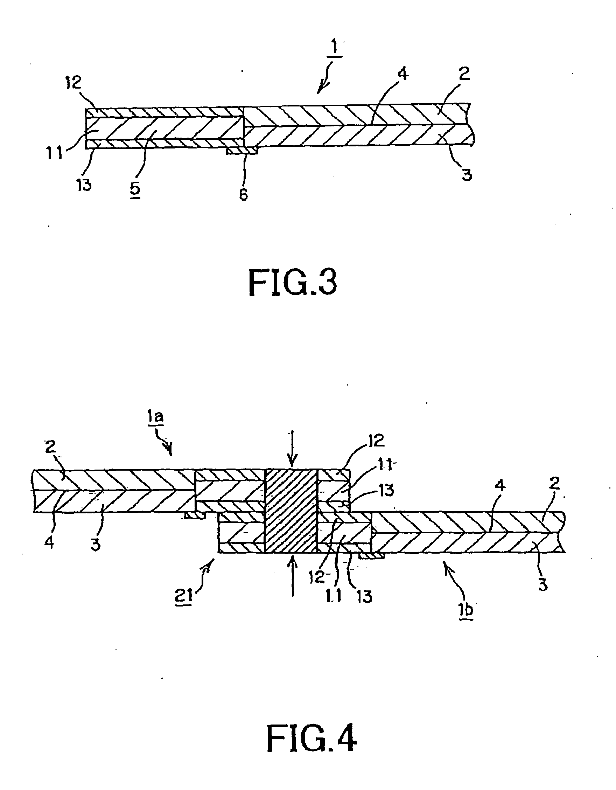

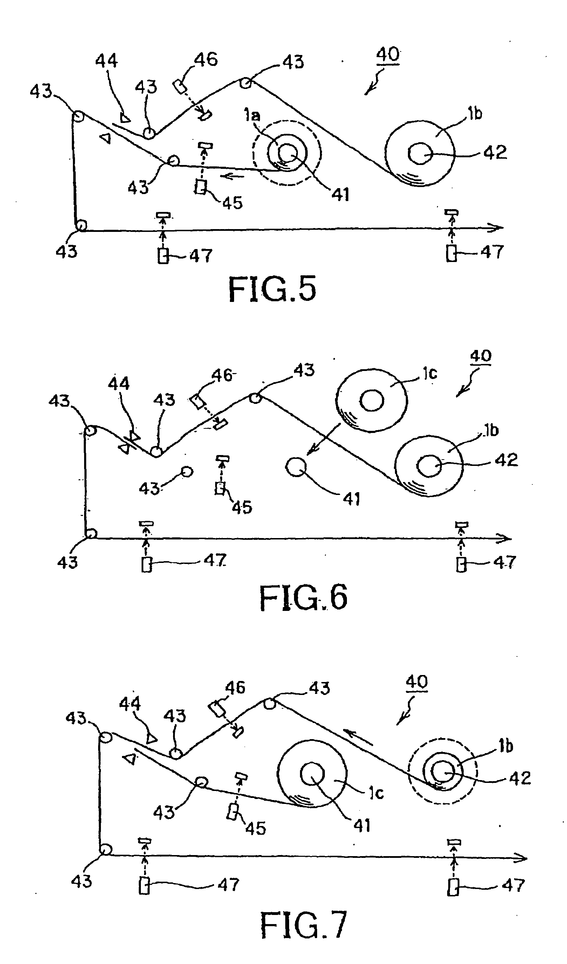

An embodiment of an anisotropic conductive film carrying tape 1 according to the present invention will now be described with reference to the drawings.
The main part of the anisotropic conductive film carrying tape 1 of the present embodiment is a base film 3 of synthetic resin on which has been affixed an anisotropic conductive film 2, as shown in Fig.3. This base film 3 may be a film of PET (polyethylene terephthalate), for example. That is, the anisotropic conductive film carrying tape 1 is mainly formed by the anisotropic conductive film 2, the PET film, as the base film 3, and a release part 4, when looking along the direction of tape thickness. The release part 4 is formed by applying releasing processing to the facing side(s) of the anisotropic conductive film 2 and/or the base film 3. Meanwhile, the release part 4 may be formed by providing a layer of a releasing agent, such as silicone, in a space between the anisotropic conductive film 2 and the base film 3.
A splice tape 5 of synthetic resin is provided at each end of the main part of the anisotropic conductive film carrying tape 1. This splice tape is designed to operate as a connection part for connection by thermal fusion to another anisotropic conductive film carrying tape. The splice tape 5 is joined by an adhesive tape 6 to the PET base film 3 of the main part of the anisotropic conductive film carrying tape 1.
The splice tape 5, as a connecting part, is made up of polypropylene films 12, 13, layered on the front and back surfaces along the direction of thickness of the PET film, as the base film 11. The polypropylene films 12, 13 are lower melting than the PET film, as the base film 11, and hence lend themselves to thermal fusion.
Meanwhile, in the splice tape 5, the polypropylene films 12, 13 for thermal fusion are layered on both sides of the base film 11. However, the material- for thermal fusion is-not limited to polypropylene such that any material suitable for thermal fusion, such as polyester, may be used.
The polypropylene films 12, 13, layered on the front and back surfaces of the base film 11, forming the splice tape 5, are dyed to respective different colors which are also different from the color of the main part. That is, the polypropylene film 12, layered on one of the surfaces of the base film 11, is dyed to a white color, while the polypropylene film 13, layered to the other surface of the base film 11, is dyed to a black color.
Since the splice tape 5, the two sides of which are dyed to different colors, are provided to both ends of the anisotropic conductive film carrying tape 1, these ends may be detected easily reliably with visual check or by optical detection means. Moreover, since the front and back sides of the splice tape 5 are dyed to different colors, those front and back sides may be discriminated by detecting the colors. The front and back sides of the anisotropic conductive film carrying tape 1, connected to these splice tapes 5, may also be discriminated from each other. Since the front and back sides of the anisotropic conductive film carrying tape 1 may be discriminated from each other, it is-possible to detect and check for occurrence of tape torsion in which the tape as it is running has its front and back sides reversed partway.
Meanwhile, in the above splice tape 5, the polypropylene films 12, 13, the front and back sides of which have been dyed to different colors, are -layered on the respective surfaces of the base film 11. It is- however also possible to print colorant materials, such as inks of different colors, on the front and back sides of the base film, for coloring, and to apply a transparent polypropylene film on each of the colored-layers.
With the anisotropic conductive film carrying tape 1 of the instant embodiment, the splice tape 5, in which the polypropylene films 12, 13, lower melting than the PET film, have been layered as the base film 11 on both sides of the base film 11, is provided at each end of the anisotropic conductive film carrying tape 1. Hence, the tape 1 may be connected easily reliably to the counterpart anisotropic conductive film carrying tape. That is, the anisotropic conductive film carrying tape 1 may be connected easily reliably to the counterpart anisotropic conductive film carrying tape by providing, on both sides of the splice tape 5, the polypropylene films 12, 13, which are low melting and hence lend themselves to thermal fusion.
Moreover, the anisotropic conductive film carrying tape 1 of the present invention may be connected easily reliably to the counterpart anisotropic conductive film carrying tape and hence may be continuously used in the packaging process, without interrupting the packaging process, thus improving the production efficiency.
Additionally, since-the splice tape 5, connected-to the anisotropic conductive film carrying tape 1 of the present invention, has its front and back sides dyed to different colors, it is possible to check the tape 1 for torsion, as the tape is being connected to the counterpart tape 1. By torsion is here meant the state in which the tape 1 has its front and back sides reversed. It is then possible to correct the tape 1 for torsion before connection to prevent the tape 1 from being connected to the counterpart tape in such a state in which the tape 1 has its front and back surfaces reversed. This torsion of the anisotropic conductive film carrying tape 1, which is liable to occur especially when the tape is elongated in length and reduced in width, may be detected beforehand and corrected. Hence, the anisotropic conductive film carrying tape 1 may be connected to the counterpart anisotropic conductive film carrying tape to form a continuous tape without surface reversion.
The above-described splice tape 5 is of a three-layered structure, comprised of the PET film as the base film 11 and the polypropylene films 12, 13 for thermal fusion, layered on the front and back sides of the base film 11. It is however sufficient to provide materials suited for thermal fusion on both sides of the splice tape. For example,-a plural number of, e.g. two, polypropylene films may be layered together to form a double-layer structure. Or, the splice film may be formed by a sole polypropylene film. In case a plural number of polypropylene films are layered on the front and back sides of the base film 11, the polypropylene films, provided on the respective surfaces, are dyed to different colors in similar manner.
An anisotropic conductive film carrying tape 21, elongated in length by connecting a plural number of the anisotropic conductive film carrying tapes 1, described above, by splice tapes 5, as connecting parts, will now be described.
The anisotropic conductive film carrying tape 21 of the instant embodiment, elongated in length, is formed by interconnecting a plural number of the anisotropic conductive film carrying tapes 1, described above. Specifically, the anisotropic conductive film carrying tape 21 is formed by interconnecting a sole anisotropic conductive film carrying tape 1 a and another sole anisotropic conductive film carrying tape 1b by thermal fusion of the splice tapes 5, provided as connecting parts at the ends of the tapes 1a and 1b, as shown in Fig.4. The polypropylene films 12, 13, provided on the respective front and back surfaces of the splice tape 5, are low melting and hence allow for connection of the anisotropic conductive film carrying tapes 1a and 1b easily and optimally.
With the anisotropic conductive film carrying tape 21 of the instant embodiment, in which the anisotropic conductive film carrying tapes 1a and 1b are interconnected by thermal fusion of the splice tapes 5 provided on the end parts of the tapes 1a and 1b. Thus, the anisotropic conductive film carrying tape may be continuously supplied to a packaging part of a packaging device, for achieving effective tape elongation, without enlarging the anisotropic conductive film carrying tape, that is, without elongating the length of the tape wound in a tape reel.
With the elongated anisotropic conductive film carrying tape 21, obtained on interconnecting plural unit anisotropic conductive film carrying tapes 1, the front and- back surfaces of the splice tapes 5, used for interconnecting the plural unit anisotropic-conductive film carrying tapes 1, have been-dyed to different colors, as described above. Hence, the distortion of the unit tapes, which may cause the front and back sides of the tapes to be reversed at the time of sequentially interconnecting the unit tapes, may be detected and cured prior to the interconnection, thereby preventing the unit tapes 1 from being interconnected in the distorted state.
Meanwhile, the unit anisotropic conductive film carrying tapes 1, taken up on the tape reel, may be sequentially interconnected by thermal fusion of the end of the anisotropic conductive film carrying tape 1a to the end of the counterpart anisotropic conductive film carrying tape 1b. In this interconnection process, the anisotropic conductive film carrying tapes, wound on the tape reel, may be sequentially interconnected to enable the resulting elongated tape to a packaging site of the anisotropic conductive film.
Referring to Figs.5 to 7, the method for packaging a part or a component on a substrate, using the above-described anisotropic conductive film carrying tape, will now be described with reference to Figs.5 to 7. This packaging method uses a plural number of anisotropic conductive film carrying tapes 1, coiled around a tape reel 15.
A packaging device 40, used for the packaging method according to the present invention, includes a first reel support 41, a second reel support 42 and a plural number of rolls 43. The first reel support 41 supports an anisotropic conductive film carrying tape 1, coiled around the tape reel 15, so as to pay out the tape 1. The second reel support 42 is used to pay out another anisotropic conductive film carrying tape 1 when the anisotropic conductive film carrying tape 1 coiled around the first reel support 41 has been used up. The rolls 43 guide the anisotropic conductive film carrying tapes from the first and second reel supports 41, 42 to a packaging site where the anisotropic conductive film carrying tape is to be affixed in position.
The packaging device 40 also includes a heat fusion unit 44 which, when the anisotropic conductive film carrying tape, supplied from the tape reel 15, carried on one of the first and second reel supports 41, 42, has been used up and depleted, overlays the end of the used-up anisotropic conductive film carrying tape on the end of the anisotropic conductive film carrying tape supplied from the tape reel carried by the other of the first and second reel supports, and thermally fuses the ends together to interconnect the two anisotropic conductive film carrying tapes.
Between the first reel support 41 and the heat fusion unit 44, there is provided a first sensor 45 for detecting the splice tape 5, as a connecting part for the trailing end of the anisotropic conductive film carrying tape supplied from the tape reel carried by the first reel support 41 when the tape is about to be depleted.
Between the second reel support 42 and the heat fusion unit 44, there is provided a second sensor 46 for detecting a bond part at the trailing-end of the anisotropic conductive film carrying tape supplied from the-tape reel carried by the second reel support 42 when the tape is about to be depleted.
The packaging device includes tape reel exchanging means, not shown, for supplying a new anisotropic conductive film carrying tape, coiled around a new tape reel, to the first or second reel support, when the anisotropic conductive film carrying tape of the tape reel carried by the first or second reel support is about to be depleted.
The packaging device also includes one or more torsion preventive sensors 47 between the heat fusion unit 44 and the packaging unit. These torsion preventive sensors 47 detect the colors of the front and back surfaces of the connecting part of the anisotropic conductive film carrying tape to help prevent distortion of the anisotropic conductive film carrying tape.
The packaging method of the present invention, employing the above-described packaging device, includes a tape supply step, an end detection step, an end connecting step and a tape reel exchange step.
In the tape supply step, the anisotropic conductive film carrying tape, wound on the tape reel on one of the first and second tape supports, for example, the anisotropic conductive film carrying tape 1a, coiled around the tape reel of the first reel support 41, is supplied to the packaging unit, as shown in Fig.5. In the end detection step, the first sensor 45 detects the colored splice tape 5, provided at the end of the anisotropic conductive film carrying tape 1a, when the tape 1a is about to be depleted. In the end connecting step, the heat fusion unit 44 heat-fuses the splice tape 5 of the an-isotropic conductive film carrying tape 1a of the first reel support 41 to the splice tape 5 of the anisotropic conductive film carrying tape 1b, coiled around another tape reel of the second reel support 42 and which is about to be used, as the two splice tapes are overlaid one on the other, as shown in Fig.6. In the tape reel exchange step, the tape reel carried on the first reel support 41 and from which the anisotropic conductive film carrying tape 1a is about to be depleted, is exchanged for the new tape reel, carrying an anisotropic conductive film carrying tape 1c.
Returning then to the tape supplying step, the anisotropic conductive film carrying tape 1b, taken up on the tape reel of the second reel support 42, is supplied to the packaging unit, as shown in Fig.7. Since the anisotropic conductive film carrying tape 1a from the tape reel of the first reel support 41, and the anisotropic conductive film carrying tape 1b from the tape reel of the second reel support 42, are supplied continuously, there is no necessity of halting the operation of the packaging unit.
Then, in the end detection step, a second sensor 46 detects the colored splice tape 5 at the end of the anisotropic conductive film carrying tape 1b. In the end connecting step, the heat fusion unit 44 heat-fuses the splice tape 5 of the anisotropic conductive film carrying tape 1b of the second reel support to the splice tape 5 of the anisotropic conductive film carrying tape 1c, coiled around a new tape reel of the first reel support 41 and which is about to be used, as the two splice tapes are overlaid one on the other. In the tape reel exchange step, the tape reel from which the anisotropic conductive film 1b, carried by the second reel support 42, is exchanged for a new tape reel, carrying an anisotropic conductive film carrying tape, as in the case of the first reel support 41 described above. Returning then to the tape supplying step, the above-described steps are repeated to provide for continuous use of the anisotropic conductive film carrying tapes.
In the above-described packaging method, the splice tape at the end part of the anisotropic conductive film carrying tape, wound on a reel and which is about to be depleted, is superposed on the splice tape of an anisotropic conductive film carrying tape, as taken up on another reel, which is ready for operation. The two splice tapes are thermally fused together and thereby interconnected extremely readily and reliably. Hence, the anisotropic conductive film carrying tapes may be supplied without interruptions to the packaging unit.
With the packaging method of the present invention, when an anisotropic conductive film carrying tape in operation is about to be depleted, the tape may be thermally fused to another anisotropic conductive film carrying tape easily reliably, as the packaging operation is continued. Hence, the anisotropic conductive film carrying tapes may be supplied in succession to the packaging unit, without halting the operation of the packaging device.
Moreover, with the packaging method, according to the present invention, the anisotropic conductive film carrying tape may be used continuously, and hence the tape length may effectively be increased, thereby improving the production efficiency.
Furthermore, with the packaging process, according to the present invention, the colors of the front and back surfaces of the connecting parts may be confirmed by the sensor. Thus, even if the anisotropic conductive film carrying tape is of a narrow width, it is possible to prevent packaging troubles otherwise caused by inversion of front or back sides caused in turn by distortion of the anisotropic conductive film carrying tape.

### Industrial Utilizability

The anisotropic conductive film carrying tape according to the present invention may extensively be used as a connection material for counterpart connection members, such as electronic devices, parts or components.

## Claims

1. An anisotropic conductive film carrying tape (1) wherein a splice tape (5) of synthetic resin (11) is joined by an adhesive tape (6) to one longitudinal end or to both longitudinal ends of a substrate of synthetic resin (3) carrying thereon an anisotropic conductive film (2), wherein
said splice tape is a polyethylene terephthalate film (11) on each of the front and back surfaces of which has been layered a polypropylene film (12, 13); and wherein
said polypropylene films (12, 13), formed on the front and back surfaces of said polyethylene terephthalate film (11), have been dyed to different colors.

2. An anisotropic conductive film carrying tape obtained on interconnecting a plurality of anisotropic conductive film carrying tapes (1) according to claim 1.

3. A packaging method for affixing electronic devices or electronic parts or components in a preset pattern, using an anisotropic conductive film carrying tape (1a, 1b) including a substrate of synthetic resin (3) carrying an anisotropic conductive film (2) affixed thereon, said packaging method comprising:
supplying an anisotropic conductive film carrying tape (1a) as claimed in claim 1, as taken up on a tape reel (41), to a packaging unit (40);
detecting an end of said anisotropic conductive film carrying tape (1a), as taken up on said tape reel (41), when said anisotropic conductive film carrying tape is about to be depleted, and thermally fusing (44) an end of said anisotropic conductive film carrying tape (1a), as taken up on said tape reel (41), to an end of an anisotropic conductive film carrying tape (1b), as taken up on another tape reel (42), to interconnect said anisotropic conductive film carrying tape (1a), as taken up on said tape reel (41), and said anisotropic conductive film carrying tape (1b), as taken up on said another tape reel (42);
exchanging the tape reel (41) from which said anisotropic conductive film carrying tape (1a) is about to be depleted, for a new tape reel, carrying thereon an anisotropic conductive film carrying tape (1c), for thereby enabling continued supply of the anisotropic conductive film carrying tape (1) to a packaging unit for electronic devices or electronic parts or components; and
subsequently affixing said anisotropic conductive film carrying tape (1a, 1b, 1c) in a preset pattern.

4. The packaging method according to claim 3 wherein
when said anisotropic conductive film carrying tape (1a) on said tape reel is about to be depleted, an end thereof is detected and the colors on the front and back surfaces of said first slice tape and said second splice tape are detected to check for a given surface of the splice tapes being a front surface or a back surface; the anisotropic conductive film carrying tape (1a) on said tape reel (41) being subsequently connected to the anisotropic conductive film carrying tape (1b) on said another tape reel (42).

5. The packaging method according to claim 3 wherein
said step of thermal fusing connects by heat fusion a polypropylene film of said first splice tape (5) to a polypropylene film of said second splice tape (5).

## Patentansprüche

1. Einen anisotropen, leitfähigen Film tragendes Band (1), wobei zu einem Klebeband (5) aus Kunstharz (11) ein selbstklebendes Band (6) an einem Längsende oder an beiden Längsenden eines Substrats aus Kunstharz (3) kommt, wobei darauf der anisotrope, leitende Film (2) getragen wird, wobei
das Klebeband ein Polyethylenterephthalatfilm (11) ist, auf dessen vorderer und rückwärtiger Oberfläche ein Polypropylenfilm (12, 13) aufgebracht ist; und wobei
die Polypropylenfilme (12, 13), die auf der vorderen und rückwärtigen Oberfläche des Polyethylenterephthalatfilms (11) gebildet sind, in unterschiedlichen Farben gefärbt sind.

2. Einen anisotropen, leitfähigen Film tragendes Band, welches durch miteinander Verbinden einer Mehrzahl von einen anisotropen, leitfähigen Film tragenden Bändern (1) gemäß Anspruch 1 erhalten wird.

3. Packverfahren zur Fixierung von elektronischen Geräten oder elektronischen Teilen oder Komponenten in einem vorgegebenen Muster, wobei ein einen anisotropen, leitfähigen Film tragendes Band (1a, 1b) verwendet wird, welches ein Substrat aus Kunstharz (3) aufweist, das einen anisotropen, leitfähigen Film (2) darauf fixiert aufweist, wobei das Packverfahren aufweist:
Zuführen eines einen anisotropen, leitfähigen Film tragenden Bands (1a) wie in Anspruch 1 beansprucht, wie es auf einer Bandrolle (41) aufgewickelt ist, zu einer Verpackungseinheit (40);
Ermitteln eines Endes des den anisotropen, leitfähigen Film tragenden Bands (1a), wie es auf einer Bandrolle (41) aufgewickelt ist, wenn das den anisotropen, leitfähigen Film tragende Band aufgebraucht ist, und thermisches Verschmelzen (44) eines Endes des den anisotropen, leitfähigen Film tragenden Bands (1a), wie es auf der Bandrolle (41) aufgewickelt ist, mit einem Ende eines einen anisotropen, leitfähigen Film tragenden Bands (1b), wie es auf einer anderen Bandrolle (42) aufgewickelt ist, um das den anisotropen, leitfähigen Film tragende Band (1a), wie es auf der Bandrolle (41) aufgewickelt ist, und das den anisotropen, leitfähigen Film tragende Band (1b), wie es auf der anderen Bandrolle (42) aufgewickelt ist, miteinander zu verbinden;
Auswechseln der Bandrolle (41), auf der das den anisotropen, leitfähigen Film tragende Band (1a) aufgebraucht sein wird, mit einer neuen Bandrolle, das darauf ein einen anisotropen, leitfähigen Film tragendes Band (1c) trägt, um **dadurch** eine fortgesetzte Zufuhr des den anisotropen, leitfähigen Film tragenden Bands (1c) an eine Packeinheit für elektronische Geräte oder elektronische Teile oder Komponenten zu ermöglichen; und
danach Fixieren des den anisotropen, leitfähigen Film tragenden Bands (1a, 1b, 1c) in einem vorgegebenen Muster.

4. Packverfahren nach Anspruch 3, wobei
wenn das den anisotropen, leitfähigen Film tragende Band (1a) auf der Bandrolle aufgebraucht wird, ein Ende davon ermittelt wird und die Farbe auf der vorderen und der rückwärtigen Oberfläche des ersten Klebebands und des zweiten Klebebands ermittelt wird, um eine vorgegebene Oberfläche der Klebebänder, die die vordere Oberfläche oder die rückwärtige Oberfläche sein sollen, zu überprüfen; wobei das den anisotropen, leitfähigen Film tragende Band (1a) der Bandrolle (41) nachfolgend mit dem den anisotropen, leitfähigen Film tragenden Band (1b) auf der anderen Bandrolle (42) verbunden wird.

5. Packverfahren gemäß Anspruch 3, wobei
der Schritt des thermischen Verschmelzens durch Wärmeverschmelzung einen Polypropylenfilm des ersten Klebebands (5) mit einem Polypropylenfilm des zweiten Klebebands (5) verbindet.

## Revendications

1. Bande portant un film conducteur anisotrope (1) où une bande d'épissage (5) de résine synthétique (11) est jointe par une bande adhésive (6) à une extrémité longitudinale ou aux deux extrémités longitudinales d'un substrat de résine synthétique (3) portant sur lui un film conducteur anisotrope (2) où
ladite bande d'épissage est un film de polyéthylène téréphtalate (11) sur chacune des surfaces frontale et dorsale duquel a été disposé en couche un film de polypropylène (12, 13) ; et où
lesdits films de polypropylène (12, 13) formés sur les surfaces frontale et dorsale dudit film de polyéthylène téréphtalate (11) ont été teints en couleurs différentes.

2. Bande portant un film conducteur anisotrope obtenue lors de l'interconnexion d'une pluralité de bandes portant des films conducteurs anisotropes (1) selon la revendication 1.

3. Procédé d'emballage pour fixer des dispositifs électroniques ou des pièces ou composants électroniques dans une configuration pré-établie, utilisant une bande portant un film conducteur anisotrope (1a, 1b) incluant un substrat de résine synthétique (3) portant un film conducteur anisotrope (2) fixé sur lui, ledit procédé d'emballage comprenant :
l'apport à une unité d'emballage (40) d'une bande portant un film conducteur anisotrope (1a) selon la revendication 1, enroulée sur une bobine de bande (41) ;
la détection d'une extrémité de ladite bande portant un film conducteur anisotrope (1a), enroulée sur ladite bobine de bande (41), quand ladite bande portant un film conducteur anisotrope est sur le point d'être épuisée, et la fusion thermique (44) d'une extrémité de ladite bande portant un film conducteur anisotrope (1a), enroulée sur ladite bobine de bande (41), à une extrémité d'une bande portant un film conducteur anisotrope (1b), enroulée sur une autre bobine de bande (42), pour interconnecter ladite bande portant un film conducteur anisotrope (1a), enroulée sur ladite bobine de bande (41), et ladite bande portant un film conducteur anisotrope (1b), enroulée sur ladite autre bobine de bande (42) ;
l'échange de la bobine de bande (41) de laquelle ladite bande portant un film conducteur anisotrope (1a) est sur le point d'être épuisée, contre une nouvelle bobine de bande portant sur elle une bande portant un film conducteur anisotrope (1c), pour permettre ainsi l'apport continué de la bande portant un film conducteur anisotrope (1c) à une unité d'emballage pour dispositifs électroniques ou pièces ou composants électroniques ; et
ensuite la fixation de ladite bande portant un film conducteur anisotrope (1a, 1b, 1c) dans une configuration pré-établie.

4. Procédé d'emballage selon la revendication 3 où
quand ladite bande portant un film conducteur anisotrope (1a) sur ladite bobine de bande est sur le point d'être épuisée, une extrémité de celle-ci est détectée et les couleurs sur les surfaces frontale et dorsale de ladite première bande d'épissage et de ladite seconde bande d'épissage sont détectées pour vérifier si une surface donnée des bandes d'épissage est une surface frontale ou une surface dorsale ; la bande portant un film conducteur anisotrope (1a) sur ladite bobine de bande (41) étant ensuite connectée à la bande portant un film conducteur anisotrope (1b) sur ladite autre bobine de bande (42).

5. Procédé d'emballage selon la revendication 3 où
ladite étape de fusion thermique connecte par fusion thermique un film de polypropylène de ladite première bande d'épissage (5) à un film de polypropylène de ladite seconde bande d'épissage (5).
